(19) **Europäisches Patentamt / European Patent Office / Office européen des brevets**

(11) **EP 1 851 368 B1**

(12) **EUROPEAN PATENT SPECIFICATION**

(45) Date of publication and mention
of the grant of the patent:
**08.08.2012 Bulletin 2012/32**

(51) Int Cl.:
***C30B 23/00*** (2006.01)   ***C30B 29/48*** (2006.01)

(21) Application number: **06709605.7**

(22) Date of filing: **02.02.2006**

(86) International application number:
**PCT/GB2006/000354**

(87) International publication number:
**WO 2006/090104 (31.08.2006 Gazette 2006/35)**

(54) **APPARATUS AND PROCESS FOR CRYSTAL GROWTH**

VORRICHTUNG UND VERFAHREN ZUM KRISTALLZIEHEN

APPAREIL ET PROCEDE DE CROISSANCE DE CRISTAUX

(84) Designated Contracting States:
**AT BE BG CH CY CZ DE DK EE ES FI FR GB GR HU IE IS IT LI LT LU LV MC NL PL PT RO SE SI SK TR**

(30) Priority: **22.02.2005 GB 0503634**

(43) Date of publication of application:
**07.11.2007 Bulletin 2007/45**

(73) Proprietor: **Kromek Limited**
**Sedgefield, Durham TS21 3FD (GB)**

(72) Inventors:
• **BASU, Arnab**
**Durham, DH1 2AW (GB)**
• **ROBINSON, Max** 1 Bishop's Court Low Road
**Durham DH1 2LY (GB)**
• **CANTWELL, Ben** 152 Highfield Rise
**County Durham, DH3 3UY (GB)**
• **BRINKMAN, Andy**
**Durham, DH1 4JA (GB)**

(74) Representative: **Howe, Steven et al**
**Reddie & Grose**
**16 Theobalds Road**
**London**
**WC1X 8PL (GB)**

(56) References cited:
**EP-B- 1 019 568    US-A- 5 707 446**

## Description

Technical Field

The present invention relates to an improved apparatus and process for vapour phase crystal growth, and crystals obtained with the apparatus or process.

Background of the Invention

In designing an effective vapour growth system which has the potential for commercial development and the production of large, highly qualified single crystals of semiconducting materials with for example cadmium telluride (CdTe), there are three major concerns including the achievement of an adequate growth rate, the need to achieve high quality single crystal over a 50 mm and larger diameter boule; and the requirement for a user friendly, robust, manufacturable but flexible design.

Until fairly recently conventional vapour transport has involved the use of a simple linear system with a source and sink of single crystals of II-VI compounds, such as CdS, ZnSe, which sublime easily from the solid phase. These together with a seed crystal are located in a sealed quartz ampoule in a tubular furnace in an arrangement for example as described in W.W. Piper and S.J. Polich, J. Appl. Phys. 32 (1961) 1278. The source and sink are at different temperatures and therefore have different equilibrium vapour pressures. This vapour pressure difference provides the driving force for growth.

This approach results in certain fundamental problem for growth of crystals such as CdTe:

The equilibrium vapour composition of CdTe is non-stoichiometric except at one temperature, the congruent evaporation temperature which is described in more detail in D. de Nobel Philips Res. Repts. 14 (1959) 361. Due to the law of mass action:

$$[Cd][Te_2]^{1/2} = K(T)$$

where [Cd] and [Te$_2$] are the concentrations of cadmium and tellurium vapour respectively and K is a constant depending on temperature, T.N. Yellin and S. Szapiro, J. Crystal Growth 69 (1984) 555 have reported that minute deviations from stoichiometry in the bulk source material result in large variations in the composition of the vapour making the transport and hence growth highly non-reproducible. Furthermore, this effect gives rise to non-stoichiometry in the growing crystal which has a detrimental effect on its useful properties.

Attempting to overcome these problems with the use of high source/sink temperatures is very difficult and does not lead to a significant improvement in growth rate.

Alternatively, control of the axial temperature gradient is also difficult in simple closed tubular systems and it is difficult to thermally isolate source and sink regions as radiation is an important thermal flux. Furthermore, exact determination of the parameters controlling growth (i.e. surface temperatures of source and seed, vapour pressures) is difficult.

This approach may be improved by the use of a reservoir containing one of the constituent elements to control the partial pressures according to the above equation . A limitation with this approach in a typical growth system is that the exact conditions of temperature and partial pressure are not determined directly and so the optimum reservoir temperature may be uncertain requiring analysis of grown crystals. This problem is compounded, in a system without *in-situ* monitoring, by any change in conditions during a growth run and run to run variations.

Another major advance in overcoming the limitations of this technology was proposed by the NASA / University of Alabama group of Rosenberger, Banish and Duval (RBD) in F. Rosenberger, M. Banish and W.M.W. Duval, NASA Technical Memorandum 103786. Their design was a tubular system with a flow restrictor between the source and the seed. A small proportion of the source material and in particular any excess material was removed preferentially through continuously pumped effusion holes, thus maintaining a near stoichiometry of the vapour phase. The first flow restrictor acted to make the mass transport rate relatively insensitive to the temperatures of the source and sink and their difference. If not restricted in this way, in a system operating under near stoichiometric conditions, appropriate transport rates would require the temperature difference between source and sink to be controlled to within a small fraction of a degree which is difficult especially if the temperatures of the source and growing surfaces cannot be measured directly. This system does, however, suffer from some significant limitations including thermal coupling along the axis of the furnace prevented the desired axial temperature profile from being obtained, direct determination of the surface temperatures of source and seed was not possible, and indirect determination uncertain due to the complexity of the radiation field, the partial pressures of source species over the source and the seed were not directly measurable and uncertainties in the flow modelling of the system and its restrictions made indirect determination uncertain and the quartz ware was complex, not easy to use and vulnerable in application.

US 5,365,876 discloses an optically transparent furnace and detector apparatus. The crystal grows by transport of vapour along a temperature gradient in an evacuated ampoule. The temperature gradient between the surface of the crystal and the source material determines the growth rate of the crystal. DE4310744 discloses an apparatus and method for bulk vapour crystal growth which comprises a passage for transport of vapour connecting a source and growth chamber. The passage for transport vapour is in a straight line direction along the length between source and growth chamber. Thus, the source and growth chambers are not thermally separated/decoupled and the production of multiple crystals in one growth cycle is not possible in either US 5,365,876 or DE4310744.

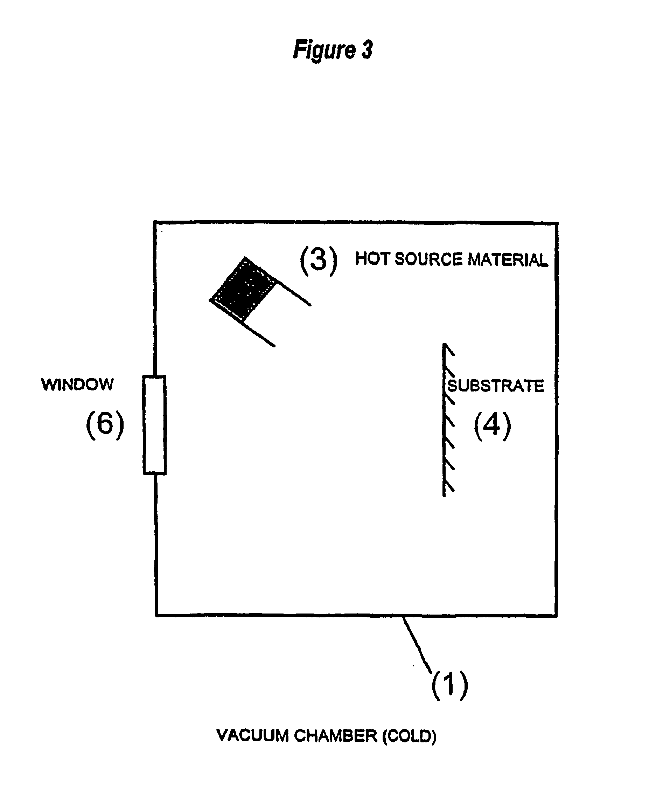

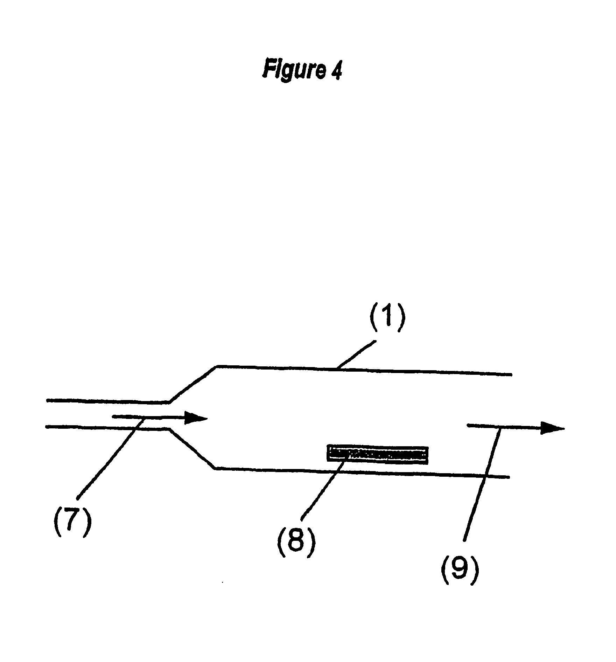

*In-situ* optical monitoring is known and routinely employed in other methods such as low temperature thin film growth, where the 'efficiency' of the process is not very important. Examples of this are Molecular Beam Epitaxy (MBE) (see Fig. 3) and Metal-Organic Vapour Phase Epitaxy (MOVPE) (see Fig. 4) however these techniques are not suitable for 'bulk' crystal growth which requires enclosed transport passages for efficient source utilisation and also requires heating of the quartz passages to allow optical access while preventing condensation prior to the growth region.

EP 1,019,568 B1 discloses an apparatus and method for bulk vapour crystal growth which comprises a passage for transport of vapour connecting a source and growth chamber where the passage deviates by an angle of at least 5° along the length of the passage between source and growth chambers. An apparatus comprising a plurality of source zones and a single growth chamber is also contemplated. This vapour growth system allows the production of large, high quality single crystals of semi-conducting materials with effective temperature and stoichiometry control. EP 1 019 568 B1 also discloses an apparatus and method for vapour phase crystal growth which enables *in-situ* monitoring in non-intrusive manner and moreover allows for substantial thermal isolation of source and sink regions by thermally separating the source material chamber from the seed crystal chamber.

The production costs of the known techniques are high. Thus, there remains the need for an apparatus for the large scale production of multiple crystals. Furthermore, there also remains the need for the production of multiple crystals with differing properties and sizes.

The present invention addresses these problems by proposing a means of producing multiple single crystals during one growth cycle. This will allow higher yields of the crystals compared with conventional techniques and result in lower production costs. It also enables the simultaneous production of crystals having different diameters and even different electrical properties.

Summary of the Invention

According to the invention, there is provided an apparatus for bulk vapour phase crystal growth as set forth in claim 1.

The apparatus comprises at least one central source chamber surrounded by a number of satellite growth tubes each containing a seed crystal. All the tubes are thermally decoupled from each other. The vapour from the source material is drawn into each growth tube using a pumping mechanism. By employing this technique a number of crystals can all be grown at the same time. Each individual growth chamber can be independently controlled in terms of temperature and vapour flow rate.

It will be understood that the terms "sink" zone or region and "growth chamber" when used in this specification are interchangeable. The term "growth chamber" is interchangeable with the term "growth tube" There are several advantages associated with an apparatus comprising a plurality of growth chambers including

(i) different diameters of material can be produced depending on the customer requirement;

(ii) different compositions can be produced (e.g. varying the Zn% in CZT, 4% Zn suitable for substrate market, 10% Zn suitable for detector applications);

(iii) dopants can be introduced wherein the doping levels can be varied, enabling simultaneous production of material with different electrical resistivity. Also according to the invention there is provided a process for bulk vapour phase crystal growth to produce multiple single crystals in one growth cycle as set forth in claim 14.

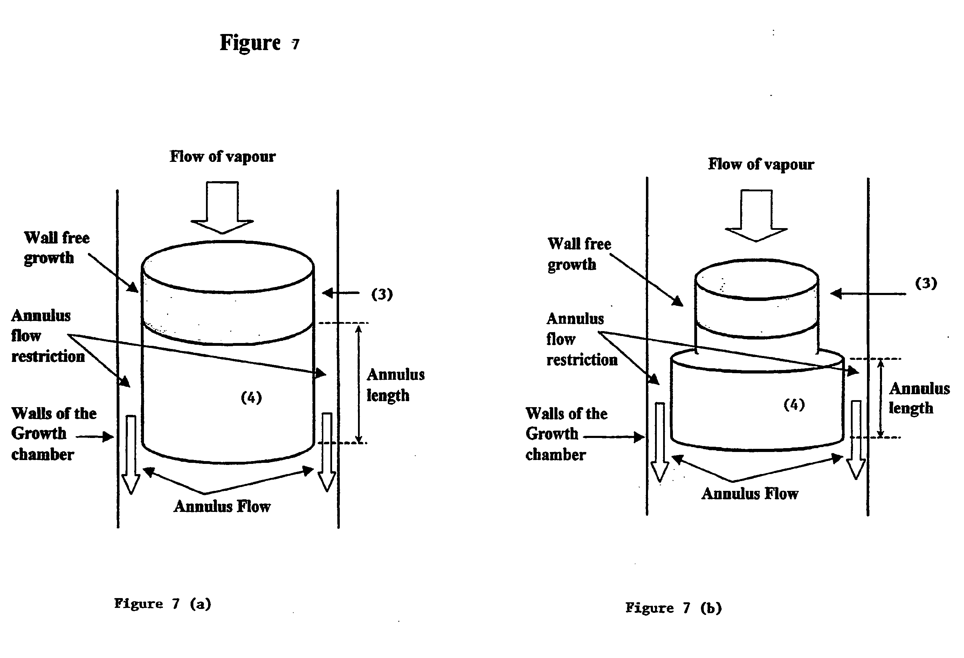

A further aspect of this invention is that in addition to the number of crystals being grown at the same time, the crystals may have varying diameter. This is effected by changing the shape of the pedestal which the seed crystal is mounted upon. The pedestal provides an annulus flow restriction (Figure 7(b)). Annulus flow restriction is achieved by a combination of the annulus gap i.e. the distance between the pedestal and side wall of the growth chamber and length of the pedestal. By modifying the shape of the pedestal, the size of the crystal to be grown and the flow restrictor function can be decoupled/separated. Furthermore, the annulus gap allows the removal of impurities and excess vapours, thereby allowing the production of purer crystals.

Furthermore, it is possible to add dopant impurities at different levels into each individual growth chamber. These dopant impurities have the effect of changing the important electrical properties of the crystal, such as resistivity, carrier mobility and carrier lifetime. Due to flow restriction and the positive pumping within the system there is no significant cross contamination between the dopant levels of each individual crystal.

Theoretical calculations have shown that the maximum resistivity that can be obtained after chemical and physical purification of CdTe is about $10^8$ ohm cm[1]. However in practice the resistivity of CdTe produced by all methods lies in between $10^4$ to $10^6$ ohm cm. However, the electrical resistivity of CdTe needs to be in excess of $10^8$ ohm cm for it to be used as a radiation detector. Therefore, it is preferable to dope CdTe with elements such as chlorine to make it suitable for application as detectors. Suitable dopants according to the invention include chlorine, indium, copper, zinc.

Chlorine can be added by subliming CdCl or a solid solution of CdTe and CdCl from the source chamber. The vapour can be transported through a multilayered quartz crossmember through a flow restrictor which allows transport only to specific growth chambers. This restricts cross contamination and allows growth of crystals with and without doping. Depending on the design of the crossmember the dopant vapour can be transported to one or all the growth chambers and the flow rate to each of the growth chambers can be altered by changing the size of the flow restrictors to the individual growth chambers.

Thus, the present invention enables the growth of a number of individual crystals during the same growth cycle. Preferably, the present invention enables the simultaneous growth of at least two crystals of different properties. For example, crystals of different diameter can be grown at the same time. Furthermore, if desired, crystals of distinctly different electrical properties can also be grown at the same time.

Means for independent temperature control enable the establishment of a temperature differential to enable solid-vapour-solid phase transition in the respective source, transport and growth chambers/growth chambers. Temperature control may therefore be selected according to the phase transitions for any given crystal which it is desired to grow, for example in the range from -150° to +2000°C, employing in each case a greater source than sink/growth chamber temperature with use of appropriate cooling and/or heating control.

Preferably, means for *in-situ* monitoring of crystal growth are present, which comprise means for providing visual and/or radiation access to the growth zone but located remote therefrom. More preferably means for direct monitoring of crystal growth comprise at least one passage for monitoring communication between the remote visual/radiation access means and the growth chamber, wherein the at least one passage for monitoring communication and the at least one passage for transport of vapour associated with any given growth chamber are coincident for at least that portion of their length proximal to the sink zone.

It is a particular advantage of the invention that the apparatus as hereinbefore defined may be operated with use of conventional or modified visual/radiation monitoring means, located external to the passages as hereinbefore defined, by means of the visual/radiation access means, for example x-ray and the like may be employed to monitor crystal growth. Moreover, the apparatus of the invention may be employed in any bulk vapour transport technique with associated advantages in crystal quality, thereby overcoming disruption of growth conditions which are inherent with known *in-situ* monitoring means proximal to the growth chamber.

Reference herein to locations remote from the at least one growth chamber is to locations at which the presence of access means as hereinbefore defined introducing temperature variation or gradient in the vapour transport passage would substantially not disrupt the conditions of temperature required for uniform growth, having regard to conditions of temperature created by means of temperature controlling means for the at least one growth chamber. In contrast reference herein to locations proximal to the at least one growth chamber are to locations which would be subject to substantial disruption of conditions of temperature under these circumstances.

In a further aspect, the present invention provides an apparatus as hereinbefore defined wherein at least one of the passage for visual /radial communication and the passage for vapour transport associated with any given growth chamber deviates by an angle of at least 5° - 270°, more preferably 30° - 180°, most preferably 45° - -110°, for example 60° - 95°.

Accordingly the passage for vapour transport may deviate by an angle as hereinbefore defined whereby means for visual/radiation access may be located in the wall of the passage for vapour transport in direct line communication with the growth chamber. For example means for visual/radiation access may comprise a visual/ radiation-transparent port sealed into an optionally continuous with the wall of the transport passage, located opposing to the sink surface.

Alternatively the configuration of respective passage for visual/radiation access and for visual/radiation access and vapour transport as hereinbefore defined may be reversed, whereby the passage for visual/radiation monitoring may deviate by an angle as hereinbefore defined from a direct line communication of source and growth chamber. In this case means for visual/radiation monitoring at its point of deviation, whereby virtual or reflected direct line access is provided with the growth chamber. For example a reflective or transmissive means such as mirrored or prism quartz may be provided in association with the visual/radiation monitoring passage at its point of deviation.

Preferably, the apparatus as hereinbefore defined comprises at least one passage for transport as hereinbefore defined, which deviates by an angle of at least 5° as hereinbefore defined along the length thereof between source and growth chambers. More preferably the passage deviates by at least 5° at two points along the length thereof whereby both zones are adapted to comprise source and sink material free from constraints of gravity, i.e. which are substantially provided on suitable support means and with the passage means extending substantially upwardly therefrom, thereby providing for optimal transport with minimum disruption of the growth process.

It is a further advantage of the apparatus of the present invention that both objects of accurate temperature control of source and growth chambers and nonintrusive monitoring of at least the growth chambers can be achieved in mutually beneficial manner, whereby positioning of monitoring access means between dedicated temperature control means prevents disruption proximal to either zone.

It is a further advantage of the invention that the apparatus is ideally suited to inclusion of a flow restrictor, for example as proposed by NASA/University of Alabama RBD group above, located remote from both zones, for example upstream of sink monitoring means, for the purpose of vapour pressure control. Preferably in-*situ* means for monitoring vapour pressure is provided associated with a flow restrictor, in the form of known vapour pressure monitoring apparatus, for example as described in J. Carles, J.T. Mullins and A.W. Brinkman, J.Crystal Growth, 174 (1997) 740, the contents of which are incorporated herein by reference.

Flow restrictions may be selected from any know restrictions and preferably comprises a capillary, porous sintered disc or the like.

The apparatus of the invention is suitably constructed of any material which is adapted for use at the temperatures envisaged for crystal growth, for example is constructed of low, ambient and high temperature resistant materials. Suitable materials are known in the art and preference is given to metal oxides, and in particular quartz, refractory oxides and graphite having the required mechanical strength and integrity, for example being reinforced with a suitable material providing mechanical strength and integrity These materials are also preferred for reason of their high purity with low risk of contamination of crystal. Preferably, the apparatus comprises a sealed or sealable structure or envelope including zones and passages as hereinbefore defined. The apparatus is suitably operated at reduced pressure and is encased in a vacuum jacket or the like.

The apparatus of the invention may be used for any bulk vapour transport techniques as hereinbefore defined. It is a particular advantage that the apparatus is adapted for growth of crystals from elemental, polycrystalline binary, ternary or other multinary compounds. It is a further advantage that the apparatus of the invention is suited for use with growth from elemental, binary, ternary of other multinary compounds requiring stoichiometry control to compensate for a degree of non-stoichiometry in vapour composition of the desired crystal. The source and growth chambers are adapted to comprise source material and seed crystal as known in the art, for example in the form of one or more reservoirs of source material comprise material in solid phase supported on a glass or other suitable surface or pedestal adapted to the processing conditions to be employed, allowing convenient and efficient vaporisation wherein vapour is transported through a path, which may deviate by an angle of at least 5° along the length thereof between source and sink crystals, thereby thermally isolating the source and growth regions.

Preferably means for monitoring radiation and transport for any given sink or seed is by coincident monitoring and transport path for at least the portion of the respective paths proximal to the sink or seed, as hereinbefore defined.

Preferably the process is operated at reduced ambient or elevated temperature as hereinbefore defined. The process is moreover operated at reduced pressure, for example in the range from 10 bar, preferably $10^{-9}$ mbar to $10^2$ mbar up to 1 bar.

The process may be started up by known means to establish a sufficient vapour pressure above source material to initiate growth.

In a further aspect of the invention there is therefore provided a method for starting up the process as hereinbefore defined in a manner to establish a sufficient vapour pressure above the source material to initiate transport.

In a further aspect of the invention there is therefore provided a method for starting up the process as hereinbefore defined in a manner to establish transport control and temperature to control in the growth chamber for controlled growth at the sink or seed.

The method for starting up is suitably operated with temperature and transport rate ramping profiles. It is a particular advantage that independent temperature control means provided with the apparatus of the invention enables temperature ramping specific to growth at the sink or seed, which may also be at a temperature lower than that at the source. It is thought that this gives rise to excellent crystal quality and may even prevent an amount of precipitation or eliminate precipitation entirely.

The process is suitably operated with means for in-situ monitoring as hereinbefore defined according to known techniques. Preferably, temperature is monitored by known means at the surface of the sink, and optionally of the source, in a manner to enable adjustment as required for optimum temperature control and stoichiometry. Likewise vapour pressure is suitably monitored between zones, for example at the location of a flow restrictor and may be adapted or adjusted as required for optimum growth.

Preferably, the process of the invention as hereinbefore defined additionally comprises direct reading of process variables, comparison with optimum values of process variables for a desired crystal growth, for example, with use of a process model, and on line optimisations thereof.

The apparatus and process of the invention as hereinbefore described are adapted for growth of any crystal employing bulk vapour transport techniques.

In a further aspect of the invention, there is provided a crystal grown with the apparatus or process of the invention. The invention is suited for growth of crystals comprising any compounds which are capable of being sublimed, having a significant vapour pressure below their melting point. Preferably crystals are selected from compounds of groups IIA, IIB, III, V, I and VII of Group IV, more preferably of groups II and V or Group IV of the Periodic Table of the Elements, for example selected from Be, Mg, Zn, Cd, Hg, S, Se, Te and I or from Si and C. Particularly useful crystals grown with the apparatus and process of the invention include cadmium telluride.

In a further aspect of the invention, there is provided the use of known monitoring equipment to monitor crystal growth with the apparatus and process of the invention.

In a still further aspect of the invention, there is provided the use of the apparatus or process of the invention for any vapour transport technique for growing semiconductor, optoelectronic and optical crystals. These crystals may be used in applications such as radiation detection, substrates for functional thick and thin films, optical elements and targets for sputtering, e beam evaporation and other techniques.

The invention is now illustrated in non-limiting manner with reference to the following figures wherein:

> Figure 1 and Figure 2 are illustrative of prior art bulk vapour phase crystal growth apparatus;

> Figure 3 and Figure 4 are illustrative of prior art MBE and MOVPE apparatus;

> Figure 5 is illustrative of the apparatus of EP 1 019 568; and

> Figures 6 and 7 are diagrammatic schemes of apparatus according to the present invention.

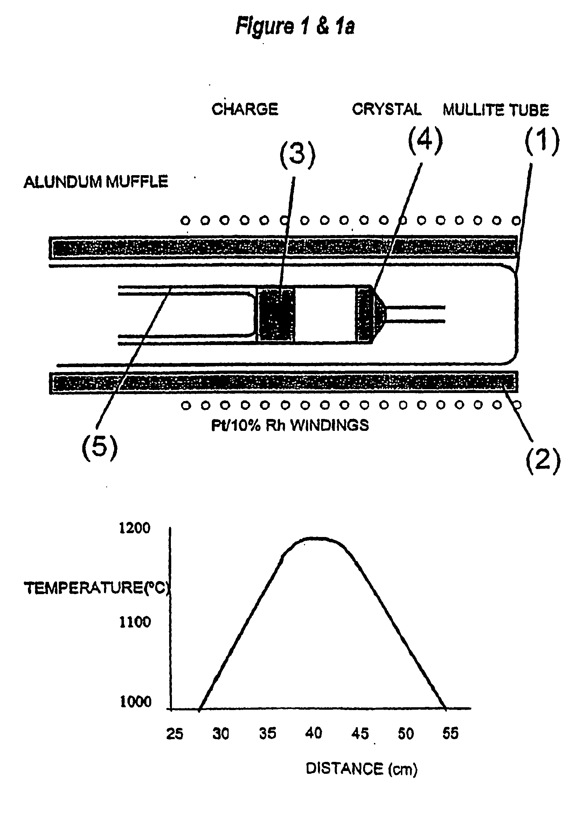

Figure 1 shows a simple linear system for vapour crystal growth comprising a sealed quartz ampoule (1) in a tubular furnace (2) have a source (3) and sink (4) for growth of cadmium sulphide, comprised in a growing crucible (5). The source and sink (3 and 4) are not thermally isolated. Moreover, there is no means for in situ monitoring of temperature or vapour pressure.

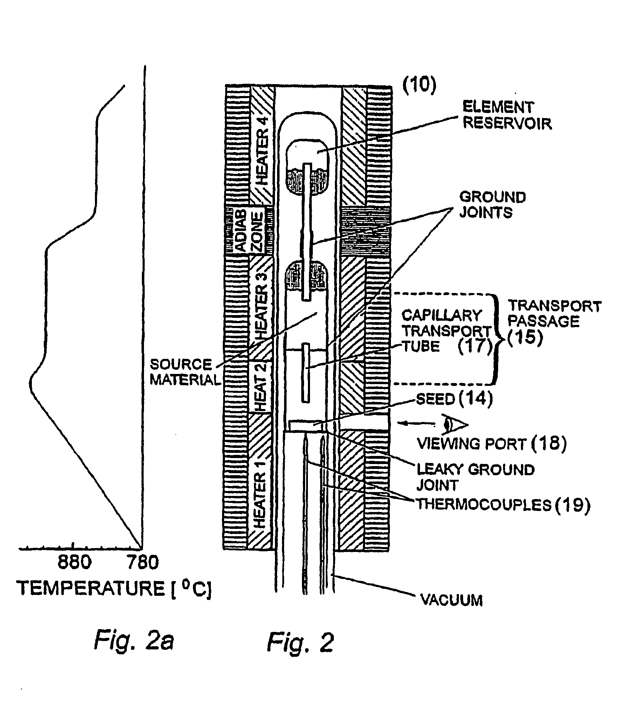

In Figure 2 is illustrated vapour phase crystal growth apparatus comprising a tubular system with a flow restrictor as designed by RB group University of Alabama. The apparatus comprises a pressure vessel (10, independent heaters (11-13) for respective sink, transport passage and source zones (14-16) having a capillary transport tube (17) as flow restrictor therebetween. A viewing port (18) located adjacent to the growth chamber (14) provides optical access to the growing crystal in the growth chamber (14). In the temperature profile shown in figure 2a it is clear that relatively stable temperatures are achieved in each zone as a result of the thermal isolation, however a slight irregularity is apparent at the level of viewing port (18) adjacent to the growth chambers, which results from a break in the cladding in order to provide the viewing access adjacent the crystal. The temperature profile shows a staged variation reaching a maximum flow restrictor (17) with graduated temperature decrease across the growth chamber (14).

In Figure 3 is shown a prior art MBE apparatus as hereinbefore described comprising vacuum chamber (1) having a temperature controlled source (3) and a temperature controlled sink (4). In situ monitoring means are provided (6) located opposite to the sink (4). Efficient source utilisation is not a concern in the process, and much of the source material sticks to the cold vacuum chamber wall.

In Figure 4 is shown a prior art MOVPE apparatus comprising a quartz envelope (1) having at one end an inlet for a metal organic source in carrier gas (7) and comprising a heated substrate (8) on to which the metal organics pyrolyse. Exhaust gases exit via outlet (9). Optical access via the quartz envelope (1) allows for in situ monitoring of the growing crystal and vapour phase conditions. However, this technique is not suitable for the growth of "bulk" crystals as the growth rates are limited and the requisite precursor metal organics are extremely expensive, especially as is in general the case, much is lost to the exhaust.

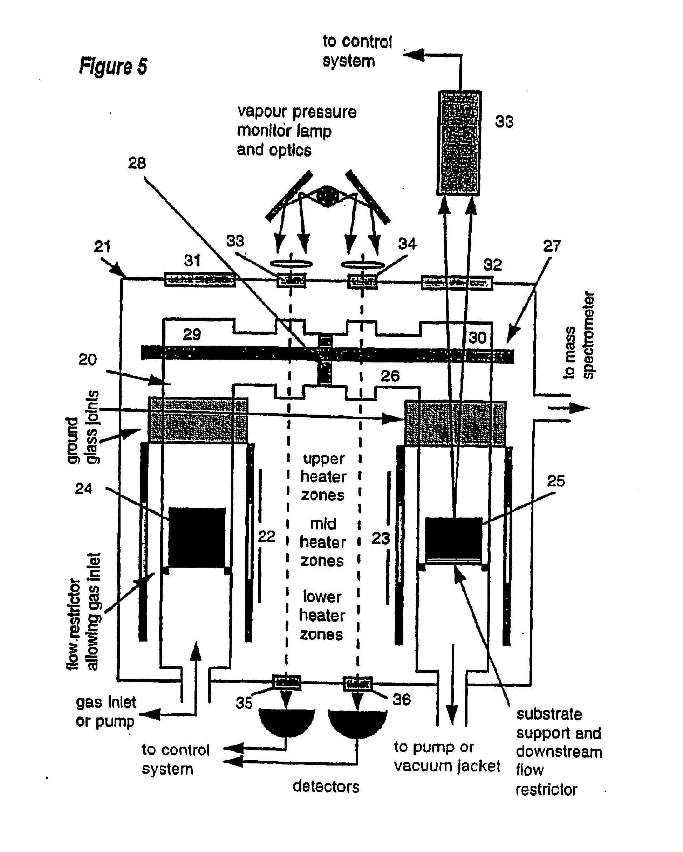

Figure 5 shows the apparatus of EP 1 019 568 in a preferred embodiment adapted for elevated temperature bulk vapour phase crystal growth. The apparatus comprises an evacuated U-tube in the form of a quartz envelope (20) encased in a vacuum jacket (21). Two separate three zone vertical tubular furnaces are provided (22 and 23) for the source zone (24) and the growth chamber (25) respectively.

The source and growth chambers are connected by passage means (26) for vapour transport comprising an optically heated horizontal cross member (27). Flow restrictor (28) is provided in passage (26). The passage for vapour transport comprises two separate points of deviation in each case at an angle of 90° providing respective junctions between diverging passages for in situ monitoring and vapour transport from source zones (29), and to growth chamber (30). Access means are provided (31 and 32) comprising windows allowing other optical access to source and sink respectively. In the apparatus as shown in situ means for monitoring of temperature of the surface of growing crystal in the growth chamber (25) are provided in the form of a pyrometer or other optical diagnostic apparatus (33) located external to the vacuum jacket and in optical communication with the surface of the growing crystal. The diagnostic apparatus is in communication with a suitable control system to vary the growth chamber temperature. The apparatus comprises additionally means for in situ monitoring of vapour pressure by further access ports (33 to 36) in the region of the flow restrictor (28), through which vapour pressure monitoring lamps and optics may be directed from a position external to the vacuum jacket with detectors located as shown at a location (35 and 36) diametrically opposed with respect to the passage for vapour transport (26). These are suitably linked to a control system providing for process control.

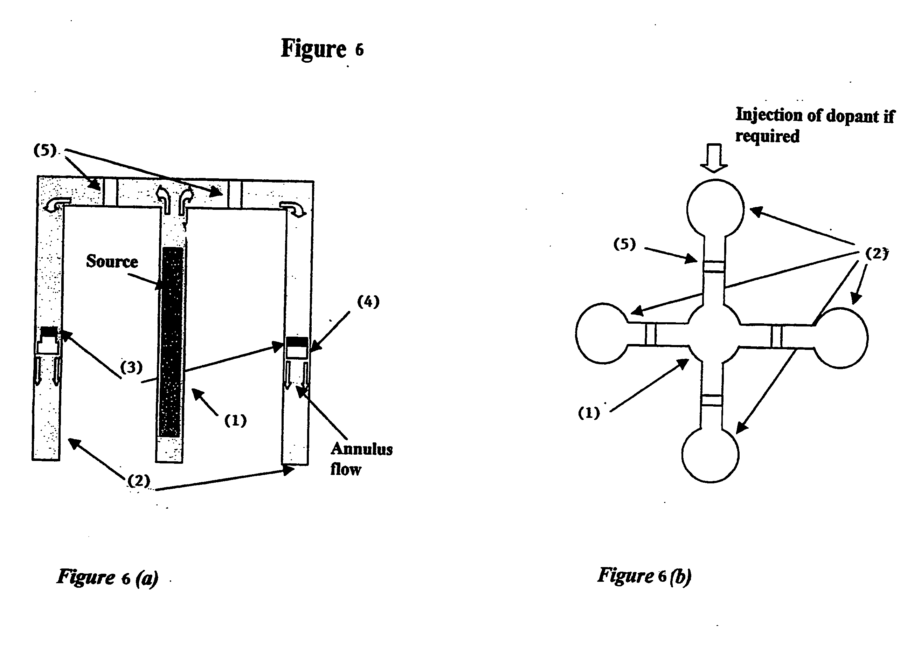

Figure 6(a) shows a side view of the apparatus of the present invention. Figure 6(b) shows a plan view of this apparatus. These figures show a central source chamber (1) surrounded by a number of satellite growth tubes (2) each containing a seed crystal (3) supported on a seed pedestal (4). It will be appreciated that more than one central source chamber may be provided, connected to some or all of the satellite growth tubes. All the tubes are thermally decoupled from each other by means of a capillary flow restrictor (5). The vapour from the source material is drawn into each growth tube using a pumping mechanism as shown by the arrows in Figure 6(a). By employing this technique a number of crystals can all be grown at the same time. Each individual growth chamber can be independently controlled in terms of temperature and vapour flow rate, thereby allowing the production of multiple crystals which may be of different diameter, as expanded below. The flow rate is controlled by a combination of the capillary flow restrictor (5) and the annulus flow restrictor (see Figure 7(b)).

The source tube, growth tube and cross member, in which transport takes place, are fabricated from quartz and the system is demountable with ground glass joints between the cross member and the two vertical tubes allowing removal of grown crystals and replenishment of source material. Radiation shields (not shown) together with the vacuum jacket which surrounds the entire system provide thermal insulation. A flow restrictor (either a capillary or a sintered quartz disc) is located in the centre of the cross member. Growth takes place on a substrate located in a quartz block in the growth tube with the gap between this glass block and the quartz envelope forming the downstream flow restrictor. Provision is made for a gas inlet to the source tube and the growth tube may be pumped by a separate pumping system or by connection to the vacuum jacket via a cool dump tube. This system provides the following : firstly, source and growth regions are thermally decoupled making the achievement of optimum axial and radial temperature profiles in the growth region more tractable, secondly, it is possible to observe both the growing surface and source material directly during growth allowing, for example, optical pyrometry or spectrometric measurements as a diagnostic for the growth process, thirdly, the layout provides for in situ measurement of the vapour pressures of the source elements by means of optical absorption measurements made through the crossmember on either side of the flow restrictor. If the flow properties of the flow restrictor are known, then these measurements also allow the mass transport rate to be determined directly during growth and fourthly, the glassware is relatively simple and robust and may, in principle, be extended to the growth of multinary compounds by the addition of source tubes connected to the growth tube by suitable flow restrictors (designed to minimise reverse flow of species and hence contamination of the source material by operating at a sufficiently high flow rate).

Figure 7(a) shows a flow restrictor of the prior art and Figure 7(b) shows a flow restrictor of the present invention. The seed pedestal (4) upon which the seed crystal (3) is mounted also provides the annulus flow restriction. This is achieved by a combination of the annulus gap and length of the pedestal. By modifying the shape of the pedestal, the size of the crystal to be grown and the flow restrictor function can be decoupled. This also assists with the requirement for crystal growth away from the walls of the growth chamber. A further aspect of this invention is that in addition to the number of crystals being grown at the same time, the crystals may have varying diameter depending on the shape of the pedestal. It is also possible to add dopant impurities at different levels into each individual growth chamber.

## Claims

1. Apparatus for vapour phase crystal growth to produce multiple single crystals in one growth cycle comprising:

   at least one source chamber (1),
   a plurality of satellite growth tubes (2) arranged around the at least one source chamber (1);
   a plurality of passage means adapted for transport of vapour from the source chamber (1) to the growth tubes (2) wherein the at least one source chamber (1) is thermally decoupled from the growth tubes (2).

2. Apparatus as claimed in claim 1, including a means arranged to allow a dopant, preferably chlorine, indium, copper or zinc, to be added into at least one growth tube (2).

3. An apparatus as claimed in any of the preceding claims including a means to control the flow rate into the growth tube (2).

4. An apparatus as claimed in any of the preceding claims wherein each growth tube (2) contains a seed crystal (3).

5. An apparatus as claimed in claim 4, wherein the seed crystal (3) is supported on a pedestal (4) or surface.

6. An apparatus as claimed in claim 5 wherein the length of the pedestal (4) in at least one growth tube (2) is different from the length of the pedestal (4) in at least one other growth tube (2).

7. An apparatus as claimed in claim 5 or 6 wherein the pedestal height range is from approximately 2 to 40 mm, preferably approximately 10 mm.

8. An apparatus according to any one of claims 5 to 7, wherein the diameter of the pedestal (4) in at least one growth tube (2) is different from the diameter of the pedestal (4) in at least one other growth tube (2).

9. An apparatus according to any one of claims 5 to 8, wherein the size of the annulus from the size of the annulus between the pedestal (4) and the side wall of the at least one growth tube (2) is different from the size of the annulus between the pedestal (4) and the side wall of at least one other growth tube (2).

10. An apparatus as claimed in any of the preceding claims which additionally comprises for *in-situ* monitoring of the growth tube (2) which is non-intrusive in terms of temperature regulation within the growth tube (2).

11. An apparatus as claimed in any of the preceding claims wherein the passage for transport of vapour deviates by an angle of at least 5° along the length thereof between source and growth tubes (1;2) thereby providing thermal decoupling between the source and growth tubes (1;2).

12. An apparatus as claimed in any of the preceding claims wherein thermal decoupling is effected by means of flow restrictors (5), located remote from and between the source chamber and growth tubes (1;2).

13. An apparatus as claimed in any of the preceding claims including a single central source chamber (1).

14. A process for bulk vapour phase crystal growth to produce multiple single crystals in one growth cycle comprising;
providing at least one source chamber (1) having a reservoir of source material, and a plurality of satellite growth tubes (2) arranged around the at least one source chamber (1), each growth tube (2) being associated with independent temperature control means; and
transporting vapour phase material between the at least one source chamber and growth tubes (1;2).

15. The process as claimed in claim 14 in which the simultaneous formation of at least two different crystals of different properties occurs.

16. The process as claimed in claim 14 wherein the input into the growth tubes (2) is varied.

17. The process as claimed in claim 14 wherein a dopant, preferably chlorine, indium, copper or zinc, is added into at least one growth tube (2).

18. The process as claimed in claim 14 wherein the flow rate into the growth tube (2) is varied.

19. Apparatus or process according to any one of the preceding claims adapted for bulk vapour transport techniques.

20. Apparatus or process according to claim 19 adapted for bulk vapour phase transport techniques for growing semiconductor, optoelectronic or optical crystals.

21. Apparatus or process according to claim 19 or claim 20, for growth crystals from elemental, polycrystalline binary, ternary or other multinary compounds.

22. Apparatus or process according to any of the preceding claims adapted for growth of crystals selected from compounds of groups IIA, IIB, III, V, VI and VII and from compounds of Group IV.

23. Apparatus or process according to claim 22, for growth of crystals selected from compounds of groups II and VI and from Group IV of the Period Table of Elements, for example selected from Be, Mg, Zn, Cd, Hg, S, Se, Te and I or selected from Si and C.

**Patentansprüche**

1. Vorrichtung zur Dampfphasen-Kristallzüchtung, um mehrere Einzelkristalle in einem Zuchtzyklus zu erzeugen, die Folgendes umfasst:

wenigstens eine Quellenkammer (1),
mehrere Satelliten-Zuchtröhren (2), die um die wenigstens eine Quellenkammer (1) herum angeordnet sind;
mehrere Kanäle für den Transport von Dampf von der Quellenkammer (1) zu den Zuchtröhren (2), wobei die wenigstens eine Quellenkammer (1) von den Zuchtröhren (2) thermisch abgekoppelt ist.

2. Vorrichtung nach Anspruch 1, die Mittel beinhaltet, um das Zugeben eines Dotierungsmittels, vorzugsweise Chlor, Indium, Kupfer oder Zink, in wenigstens eine Zuchtröhre (2) zu ermöglichen.

3. Vorrichtung nach einem der vorherigen Ansprüche mit einem Mittel zum Regeln der Durchflussrate in die Zuchtröhre (2).

4. Vorrichtung nach einem der vorherigen Ansprüche, wobei jede Zuchtröhre (2) einen Keimkristall (3) enthält.

5. Vorrichtung nach Anspruch 4, wobei der Keimkristall (3) auf einem Sockel (4) oder einer Oberfläche liegt.

6. Vorrichtung nach Anspruch 5, wobei sich die Länge des Sockels (4) in wenigstens einer Zuchtröhre (2) von der Länge des Sockels (4) in wenigstens einer anderen Zuchtröhre (2) unterscheidet.

7. Vorrichtung nach Anspruch 5 oder 6, wobei die Sok-

kelhöhe im Bereich von etwa 2 bis 40 mm liegt oder vorzugsweise etwa 10 mm beträgt.

**8.** Vorrichtung nach einem der Ansprüche 5 bis 7, wobei sich der Durchmesser des Sockels (4) in wenigstens einer Zuchtröhre (2) vom Durchmesser des Sockels (4) in wenigstens einer anderen Zuchtröhre (2) unterscheidet.

**9.** Vorrichtung nach einem der Ansprüche 5 bis 8, wobei sich die Größe des Annulus von der Größe des Annulus zwischen dem Sockel (4) und der Seitenwand der wenigstens einen Zuchtröhre (2) von der Größe des Annulus zwischen dem Sockel (4) und der Seitenwand von wenigstens einer anderen Zuchtröhre (2) unterscheidet.

**10.** Vorrichtung nach einem der vorherigen Ansprüche, die zusätzlich für die In-situ-Überwachung der Zuchtröhre (2) [sic] umfasst, die bezüglich Temperaturregulierung in der Zuchtröhre (2) nichtintrusiv ist.

**11.** Vorrichtung nach einem der vorherigen Ansprüche, wobei der Kanal für den Transport von Dampf um einen Winkel von wenigstens 5 ° über seine Länge zwischen der Quelle und den Zuchtröhren (1; 2) abweicht, um dadurch eine thermische Abkopplung zwischen der Quelle und den Zuchtröhren (1; 2) zu erzielen.

**12.** Vorrichtung nach einem der vorherigen Ansprüche, wobei die thermische Abkopplung durch Durchflussbegrenzer (5) erzielt wird, die sich fern von und zwischen der Quellenkammer und den Zuchtröhren (1; 2) befinden.

**13.** Vorrichtung nach einem der vorherigen Ansprüche mit einer einzelnen zentralen Quellenkammer (1).

**14.** Verfahren zum Bulk-Dampfphasen-Kristallzüchten, um mehrere Einzelkristalle in einem Zuchtzyklus zu erzeugen, das Folgendes beinhaltet:

Bereitstellen von wenigstens einer Quellenkammer (1) mit einem Quellenmaterialvorrat und mehreren Satelliten-Zuchtröhren (2), die um die wenigstens eine Quellenkammer (1) herum angeordnet sind, wobei jede Zuchtröhre (2) mit unabhängigen Temperaturregelmitteln assoziiert ist; und
Transportieren von Dampfphasenmaterial zwischen der wenigstens einen Quellenkammer und den Zuchtröhren (1; 2).

**15.** Verfahren nach Anspruch 14, bei dem die gleichzeitige Bildung von wenigstens zwei unterschiedlichen Kristallen von unterschiedlichen Eigenschaften auftritt.

**16.** Verfahren nach Anspruch 14, wobei der Eingang in die Zuchtröhren (2) variiert wird.

**17.** Verfahren nach Anspruch 14, wobei ein Dotierungsmittel, vorzugsweise Chlor, Indium, Kupfer oder Zink, in wenigstens eine Zuchtröhre (2) gegeben wird.

**18.** Verfahren nach Anspruch 14, wobei die Durchflussrate in die Zuchtröhre (2) variiert wird.

**19.** Vorrichtung oder Verfahren nach einem der vorherigen Ansprüche, die/das für Bulk-Dampftransporttechniken ausgelegt ist.

**20.** Vorrichtung oder Verfahren nach Anspruch 19, die/das für Bulk-Dampfphasentransporttechniken zum Züchten von Halbleiter-, Optoelektronik- oder Optikkristallen adaptiert ist.

**21.** Vorrichtung oder Verfahren nach Anspruch 19 oder Anspruch 20 zum Züchten von Kristallen aus elementaren, polykristallinen binären, ternären oder anderen multinären Verbindungen.

**22.** Vorrichtung oder Verfahren nach einem der vorherigen Ansprüche zum Züchten von Kristallen, ausgewählt aus Verbindungen der Gruppen IIA, IIB, III, V, VI und VII und Verbindungen der Gruppe IV.

**23.** Vorrichtung oder Verfahren nach Anspruch 22 zum Züchten von Kristallen, ausgewählt aus Verbindungen der Gruppen II und VI und von Gruppe IV des Periodensystems der Elemente, z.B. ausgewählt aus Be, Mg, Zn, Cd, Hg, S, Se, Te und I oder ausgewählt aus Si und C.

**Revendications**

**1.** Appareil pour la croissance de cristaux en phase vapeur afin de produire de multiples cristaux uniques en un cycle de croissance, comprenant :

au moins une chambre de source (1),
une pluralité de tubes de croissance satellites (2) arrangés autour de la au moins une chambre de source (1);
une pluralité de moyens de passage adaptés pour le transport de la vapeur de la chambre de source (1) aux tubes de croissance (2), où la au moins une chambre de source (1) est thermiquement découplée des tubes de croissance (2).

**2.** Appareil selon la revendication 1, incluant un moyen arrangé pour permettre qu'un dopant, de préférence du chlore, de l'indium, du cuivre ou du zinc, soit ajouté dans au moins un tube de croissance (2).

**3.** Appareil selon l'une quelconque des revendications précédentes, incluant un moyen pour contrôler la vitesse d'écoulement dans le tube de croissance (2).

**4.** Appareil selon l'une quelconque des revendications précédentes, dans lequel chaque tube de croissance (2) contient un germe cristallin d'inoculation (3).

**5.** Appareil selon la revendication 4, dans lequel le germe cristallin d'inoculation (3) est soutenu sur un socle (4) ou une surface.

**6.** Appareil selon la revendication 5, dans lequel la longueur du socle (4) dans au moins un tube de croissance (2) est différente de la longueur du socle (4) dans au moins un autre tube de croissance (2).

**7.** Appareil selon la revendication 5 ou 6, dans lequel la plage de hauteur de socle va d'environ 2 à 40 mm, de préférence d'environ 10 mm.

**8.** Appareil selon l'une quelconque des revendications 5 à 7, dans lequel le diamètre du socle (4) dans au moins un tube de croissance (2) est différent du diamètre du socle (4) dans au moins un autre tube de croissance (2).

**9.** Appareil selon l'une quelconque des revendications 5 à 8, dans lequel la taille de l'espace annulaire de la taille de l'espace annulaire entre le socle (4) et la paroi latérale du au moins un tube de croissance (2) est différente de la taille de l'espace annulaire entre le socle (4) et la paroi latérale d'au moins un autre tube de croissance (2).

**10.** Appareil selon l'une quelconque des revendications précédentes, lequel comprend en plus la surveillance *in situ* du tube de croissance (2), laquelle est non intrusive en termes de régulation de la température dans le tube de croissance (2).

**11.** Appareil selon l'une quelconque des revendications précédentes, dans lequel le passage pour le transport de vapeur dévie d'un angle d'au moins 5° le long de la longueur de celui-ci entre la source et les tubes de croissance (1;2), assurant ainsi un découplage thermique entre la source et les tubes de croissance (1;2).

**12.** Appareil selon l'une quelconque des revendications précédentes, dans lequel le découplage thermique est effectué au moyen de dispositifs d'étranglement d'écoulement (5), situés à l'écart de et entre la chambre de source et les tubes de croissance (1;2).

**13.** Appareil selon l'une quelconque des revendications précédentes, incluant une seule chambre de source centrale (1).

**14.** Procédé de croissance en masse de cristaux en phase vapeur pour fournir de multiples cristaux uniques en un cycle de croissance, comprenant :

fournir au moins une chambre de source (1) ayant un réservoir de matériau de source et une pluralité de tubes de croissance satellites (2) arrangés autour de la au moins une chambre de source (1), chaque tube de croissance (2) étant associé à des moyens de contrôle de température indépendants; et
transporter un matériau en phase vapeur entre la au moins une chambre de source et les tubes de croissance (1;2).

**15.** Procédé selon la revendication 14, dans lequel la formation simultanée d'au moins deux cristaux différents de propriétés différentes survient.

**16.** Procédé selon la revendication 14, dans lequel l'apport dans les tubes de croissance (2) est varié.

**17.** Procédé selon la revendication 14, dans lequel un dopant, de préférence du chlore, de l'indium, du cuivre ou du zinc, est ajouté dans au moins un tube de croissance (2).

**18.** Procédé selon la revendication 14, dans lequel la vitesse d'écoulement dans le tube de croissance (2) est variée.

**19.** Appareil ou procédé selon l'une quelconque des revendications précédentes, adapté aux techniques de transport de vapeur en masse.

**20.** Appareil ou procédé selon la revendication 19, adapté aux techniques de transport en phase vapeur en masse destinées à la croissance de cristaux semi-conducteurs, optoélectroniques ou optiques.

**21.** Appareil ou procédé selon la revendication 19 ou la revendication 20, destiné à la croissance de cristaux à partir de composés élémentaires, binaires polycristallins, ternaires ou autres composés multinaires.

**22.** Appareil ou procédé selon l'une quelconque des revendications précédentes, adapté pour la croissance de cristaux sélectionnés parmi des composés des groupes IIA, IIB, III, V, VI et VII et parmi des composés du Groupe IV.

**23.** Appareil ou procédé selon la revendication 22, destiné à la croissance de cristaux sélectionnés parmi des composés des groupes II et VI et du Groupe IV du tableau périodique des éléments, sélectionnés par exemple parmi Be, Mg, Zn, Cd, Hg, S, Se, Te et I ou sélectionnés parmi Si et C.

## Figure 1 & 1a

CHARGE        CRYSTAL   MULLITE TUBE

(4)      (1)

(3)

ALUNDUM MUFFLE

Pt/10% Rh WINDINGS

(5)

(2)

Fig. 2a        Fig. 2

# Figure 3

**Figure 4**

**Figure 5**

**Figure 6**

Injection of dopant if required

(2)

(5)

(1)

*Figure 6 (b)*

(4)

Annulus flow

(1)

Source

(3)

(2)

(5)

*Figure 6 (a)*

Figure 7

Flow of vapour

(3)

Annulus length

(4)

Annulus Flow

Wall free growth

Annulus flow restriction

Walls of the Growth chamber

Figure 7 (a)

Flow of vapour

(3)

Annulus length

(4)

Annulus Flow

Wall free growth

Annulus flow restriction

Walls of the Growth chamber

Figure 7 (b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5365876 A
- DE 4310744
- EP 1019568 B1
- EP 1019568 A

**Non-patent literature cited in the description**

- **W.W. PIPER ; S.J. POLICH.** *J. Appl. Phys.,* 1961, vol. 32, 1278
- **D. DE NOBEL PHILIPS.** *Res. Repts.,* 1959, vol. 14, 361
- **T.N. YELLIN ; S. SZAPIRO.** *J. Crystal Growth,* 1984, vol. 69, 555
- **J. CARLES ; J.T. MULLINS ; A.W. BRINKMAN.** *J.Crystal Growth,* 1997, vol. 174, 740